# FASCICULE DE BREVET EUROPEEN

(11) **EP 1 703 547 B1**
(45) Date de publication et mention de la délivrance du brevet: **14.09.2011**
(21) Numéro de dépôt: 06300207.5
(22) Date de dépôt: 07.03.2006
(51) Int. Cl.: H01L 21/00

(54) **Procédé et dispositif pour le contrôle de la contamination des plaquettes de substrat**
Verfahren und Vorrichtung zur Kontrolle der Verunreinigung von Wafersubstraten
Method and device for controlling the contamination of wafer substrates

(30) Priorité: 18.03.2005 FR 0550703
(43) Date de publication de la demande: 20.09.2006
(73) Titulaire: Alcatel Lucent, 75008 Paris (FR)
(72) Inventeur: Favre, Arnaud, 74000, ANNECY (FR); Thollot, Rémi, 74350, CRUSEILLES (FR); Metais, Xavier, 74960 Meythet (FR); Desbiolles, Jean-Pierre, 74350, CRUSEILLES (FR)
(74) Mandataire: Croonenbroek, Thomas Jakob

(56) Documents cités:
- DE-A1- 10 133 520
- US-A- 5 233 191
- US-A1- 2004 023 419
- US-B1- 6 287 023

## Description

La présente invention concerne le contrôle de la contamination de pièces telles que des plaquettes de substrat (wafers) dans les procédés de fabrication de semi-conducteurs ou de microsystèmes électromécaniques (MEMS).

La taille de plus en plus faible des éléments actifs des semi-conducteurs ou des microsystèmes électromécaniques les rend de plus en plus sensibles à la présence de corps étrangers à leur surface ou dans leur masse. Ces corps étrangers sont véhiculés généralement par l'atmosphère qui entoure les plaquettes de substrat pendant les procédés. Il est par conséquent nécessaire de réduire le plus possible la présence de corps étrangers, que l'on désigne de façon générale par contamination, pendant les procédés de fabrication de semi-conducteurs ou de microsystèmes électromécaniques.

Pour cette raison, les procédés de fabrication sont réalisés dans des salles blanches, dans lesquelles l'atmosphère intérieure est maintenue avec un taux de contamination très bas. Simultanément, on contrôle en permanence le taux de contamination dans l'atmosphère intérieure de la salle blanche.

Par exemple, le document US-2004/0023419 décrit une méthode de mesure de la contamination adsorbée sur les surfaces optiques destinées aux procédés de photolithographie. La méthode utilise un polymère qui a une capacité élevée pour adsorber les composés susceptibles de constituer une contamination gazeuse. Le polymère est ensuite analysé en utilisant la désorption thermique, la chromatographie en phase gazeuse et la spectrométrie de masse. De préférence, le polymère doit rester présent dans l'atmosphère à contrôler pendant une durée suffisante de l'ordre de quelques heures à quelques jours ou quelques semaines, pour permettre la collection d'une masse suffisante de contaminants lorsqu'ils sont présents en concentration relativement basse dans l'atmosphère. L'inconvénient est que la mesure se fait en temps différé, et ne permet pas de réagir de façon fine et rapide lors de la présence de contaminations gazeuses à faible concentration.

Le document DE-101 33 520 décrit un autre système qui détermine les propriétés de l'atmosphère intérieure d'une salle blanche utilisée pour la fabrication des semi-conducteurs. Le système est incorporé dans une enceinte de transport normalisée à ouverture frontale (FOUP), pour présenter l'encombrement habituel des enceintes de transport contenant les plaquettes de substrat en cours de fabrication. L'enceinte de transport contenant le système de contrôle aspire l'air ambiant de la salle blanche, l'analyse, et le rejette dans la salle blanche, permettant un contrôle de l'atmosphère de la salle blanche le long du chemin parcouru par les enceintes de transport normalisées (FOUP) contenant les plaquettes de substrat. Les paramètres mesurés peuvent être la température de l'air de la salle blanche, la teneur en vapeur d'eau, la pollution par des particules, la pollution par certains gaz indésirables. Le système de mesure doit être adapté pour avoir un encombrement inférieur à l'espace intérieur disponible dans une enceinte de transport normalisée à ouverture frontale (FOUP).

A cause de cette faible taille, les dispositifs de mesure ne permettent pas la mesure des très faibles niveaux de contamination gazeuse à l'état de trace de l'ordre du ppb.

D'autre part, les dispositifs précités ne diagnostiquent pas l'atmosphère contenue dans les enceintes elles-mêmes de transport de plaquettes de substrat, les mesures s'effectuant globalement sur l'atmosphère de la salle blanche contenant les enceintes de transport de plaquettes de substrat.

Or les enceintes de transport de substrat sont des environnements poreux qui concentrent les contaminants et en particulier des contaminants organiques, aminés ou acides. Les plaquettes de substrat sont continuellement en attente dans ces atmosphères. En sortie des procédés de traitement pour la fabrication de semi-conducteurs, les plaquettes de substrat sont chargées de gaz de procédé, et ces gaz s'échappent des plaquettes de substrat et viennent charger les parois des enceintes de transport, qui se trouvent ainsi contaminées. Ces contaminations sont très néfastes pour les substrats de semi-conducteur tels que les plaquettes ou les masques.

On constate que les méthodes de contrôle de contamination connues ne permettent pas un contrôle suffisant, notamment en cas de faible niveau de contamination gazeuse des plaquettes de substrat ou autres pièces. Ces contaminations gazeuses à faible niveau, de type contamination moléculaire par substitution, addition ou dopage de la surface des plaquettes de substrat, peuvent créer des défauts qui peuvent ne pas être visibles en sortie de fabrication par les techniques actuelles de mesure, mais qui vont engendrer une durée de vie réduite des semi-conducteurs ou microsystèmes électromécaniques ainsi fabriqués.

La contamination moléculaire de faible niveau, par substitution, addition ou dopage des substrats, est un réel problème. Le semi-conducteur ainsi réalisé peut être déclaré satisfaisant en sortie de production, mais on constate que sa durée de vie peut être réduite. Il y a donc un grand intérêt à réduire ces contaminations moléculaires de faible niveau.

Le problème proposé par la présente invention est de réduire encore les risques de défaut apparaissant dans les semi-conducteurs et microsystèmes électromécaniques fabriqués dans des procédés de fabrication ayant des étapes de transport et/ou de stockage des plaquettes de substrat dans des enceintes de transport.

L'invention vise simultanément à éviter tout risque de contamination supplémentaire des substrats par adjonction de matériaux tels que les polymères d'adsorption gazeuse.

L'invention vise également à réduire les risques de transmission des contaminations par les plaquettes de substrat ou autres pièces contenues dans les enceintes de transport.

L'idée qui est à la base de l'invention est d'effectuer un contrôle de l'atmosphère intérieure des enceintes de transport elles-mêmes, par des moyens d'analyse externes performants mis en communication avec l'atmosphère interne de l'enceinte de transport.

De la sorte, les moyens d'analyse peuvent avoir un encombrement qui soit indépendant, notamment supérieur au volume intérieur des enceintes de transport normalisées, et de façon à conserver, pendant l'analyse, l'isolement des plaquettes de substrat éventuellement contenues dans l'enceinte de transport normalisée.

Il est ainsi possible d'utiliser des moyens d'analyse permettant de réaliser une analyse en temps réel, c'est-à-dire en un temps très court, et capables de déceler et de mesurer des concentrations très faibles de contaminations gazeuses, soit des concentrations de l'ordre du ppb.

Pour atteindre ces buts ainsi que d'autres, l'invention propose un dispositif pour le contrôle de la contamination des plaquettes de substrat ou autres pièces dans les procédés de fabrication de semi-conducteurs ou de microsystèmes électromécaniques ayant des étapes de transport et/ou de stockage des plaquettes de substrat ou autres pièces dans des enceintes de transport ; le dispositif comprenant un analyseur de gaz, ayant des moyens pour ioniser des gaz et des moyens pour identifier les gaz ionisés par la mesure d'un paramètre des ions.

Selon l'invention, les moyens pour ioniser les gaz sont aptes à ioniser des gaz à pression atmosphérique et le dispositif comprend en outre des moyens d'interface pour mettre en communication directe l'analyseur de gaz avec l'atmosphère interne d'au moins une enceinte de transport, de manière à effectuer une analyse en temps réel des gaz contenus dans l'atmosphère interne de l'enceinte de transport.

De préférence les moyens d'interface sont aptes à conduire, directement et sans apport extérieur significatif, un flux de gaz à analyser depuis l'atmosphère interne d'au moins une enceinte de transport jusqu'à l'analyseur de gaz. On entend par apport extérieur aussi bien un gaz provenant de l'extérieur qu'un gaz de purge.

Ainsi le dispositif capte les gaz de la boite et uniquement ceux provenant de la boite, grâce au volume juste suffisant des moyens d'interface et au matériau utilisé dans ces moyens pour le prélèvement et l'acheminement des gaz vers l'analyseur de gaz (tuyaux, corps des électrovannes et corps de pompes...). Avantageusement, les moyens d'interface sont constitué d'un matériau qui est le perfluoroalkoxy (PFA) pour sa bonne stabilité chimique et mécanique et son imperméabilité aux gaz. Son utilisation permet ainsi de minimiser l'adsorption et le relarguage des gaz par le matériau, propriété indispensable pour les mesures au ppb (part per billion).

Grâce à cette disposition, il est possible de faire une analyse en temps réel des traces de gaz contaminants contenues dans les enceintes de transport. L'analyse est également faite dans l'atmosphère au plus près des plaquettes de substrat ou autres pièces, et l'analyse n'est pas perturbée par l'ambiance, c'est-à-dire par l'atmosphère qui environne les enceintes de transport.

Le dispositif peut être utilisé pour contrôler la contamination de plaquettes de substrat, de masques, de pièces constitutives des chambres de procédés telles que des pièces à nettoyer périodiquement, ou même d'enceintes de transport.

De préférence, les moyens d'interface comportent des moyens d'isolement garantissant que le flux de gaz à analyser parvenant à l'analyseur de gaz provient majoritairement de l'enceinte de transport, le flux résultant des fuites provenant de l'atmosphère extérieure à l'enceinte de transport étant minoritaire. On augmente ainsi la sensibilité de l'analyse.

Le dispositif selon l'invention comprend en outre au moins une enceinte de transport.

Pour réaliser une analyse suffisamment sensible pour détecter les traces de contamination gazeuse, une possibilité est d'utiliser un analyseur de gaz qui est d'un type permettant de mesurer la mobilité des ions.

Dans la description et dans les revendications, le paramètre de mobilité des ions est défini comme le rapport entre d'une part la vitesse limite atteinte par un ion placé dans un champ électrique du fait des forces de freinage dues à la viscosité du milieu, et d'autre part le champ électrique auquel est soumis l'ion.

En alternative, l'analyseur de gaz peut être d'un type permettant de mesurer le temps de vol des ions. Le paramètre de temps de vol est défini comme le temps qui est nécessaire à un ion soumis à un champ électrique pour parcourir une distance donnée.

Pour ioniser les gaz à analyser, une possibilité est de recourir, de façon traditionnelle, à un craquage des molécules gazeuses par bombardement électronique, selon le principe de l'instrumentation IMS.

Selon une autre possibilité, l'ionisation peut être réalisée selon la technologie IAMS (Ion Attachment Mass Spectrometer), dans laquelle on bombarde le gaz à analyser avec des ions alcalins, par exemple des ions Li⁺ ou Na⁺, qui s'attachent aux molécules de gaz en réalisant ainsi un cation. On mesure alors la masse de l'ion obtenu, à l'aide d'un spectromètre de masse, et on détermine comme paramètre la masse de la molécule de gaz par soustraction de la masse connue de l'ion alcalin.

En pratique, les moyens d'interface peuvent avantageusement comprendre :
- au moins un passage traversant la paroi de l'enceinte de transport,
- un adaptateur conformé de façon que l'enceinte de transport puisse être accouplée sur l'adaptateur avec ledit passage mis sélectivement en communication avec une canalisation conduisant à l'analyseur de gaz.

Selon une première possibilité, l'adaptateur comprend des moyens de positionnement pour placer l'enceinte de transport en une position telle que ledit passage est face à l'orifice de la canalisation conduisant à l'analyseur de gaz.

Dans ce cas, les moyens de positionnement peuvent comprendre au moins un picot pour s'engager dans un trou correspondant.

Selon une autre possibilité, on peut prévoir que :
- l'enceinte de transport comprend au moins une porte,
- l'adaptateur comprend des moyens pour ouvrir sélectivement ladite porte, et des moyens collecteurs pour prélever les gaz de l'enceinte de transport et les transmettre à l'analyseur de gaz tout en limitant le prélèvement de gaz de fuite issus de l'atmosphère environnante.

Selon une forme d'exécution de l'invention, l'adaptateur peut être intégré directement sur des moyens de chargement des boites de transport à ouverture frontale, notamment des boîtes à ouverture latérale de type FOUP (Front Opening Universal Pod) ou des boîtes à ouverture inférieure de type SMIF. Ces moyens de chargement sont situées à l'entrée de l'installation comprenant une chambre de traitement de substrats semi-conducteurs. Ils permettent l'ouverture et la fermeture des boites avant l'entrée des plaquettes de substrat dans la chambre de traitement.

De la sorte, le dispositif selon l'invention permet de contrôler la contamination des substrats, et/ou des boites de transport avant leur ouverture et leur mise en communication avec les chambres de traitement des équipements, afin de limiter la pollution des chambres. De la même manière, après le traitement et avant la mise en stockage des plaquettes de substrat dans les boites de transport, on vérifie que l'atmosphère interne des boites soit propre afin que les plaquettes ne séjournent pas dans une atmosphère contaminée.

En alternative, les moyens d'interface peuvent comprendre une aiguille capable de percer la paroi d'une enceinte de transport et raccordée à l'analyseur de gaz. Cette solution peut convenir pour une utilisation avec des enceintes de transport à paroi rigide telles que les enceintes de transport de type FOUP ou SMIF, en prévoyant une portion de paroi adaptée pour être percée. Elle peut convenir aussi pour une utilisation avec des enceintes de transport de type enveloppe à paroi souple.

Le dispositif de contrôle selon l'invention peut avantageusement comprendre des moyens pour injecter sélectivement un gaz neutre de purge dans l'analyseur de gaz. Le gaz neutre peut par exemple être l'azote, fourni par une source d'azote.

On peut également prévoir des moyens pour mettre sélectivement en communication directe l'entrée de l'analyseur de gaz avec l'atmosphère environnante autour de l'enceinte de transport. De la sorte, le dispositif peut également analyser l'atmosphère de la salle blanche autour des enceintes de transport.

Les moyens d'interface comprennent alors les canalisations conduisant les gaz prélevés, ainsi que les vannes insérées dans ces canalisations pour commander le passage des gaz prélevés.

La fiabilité de l'analyse est encore améliorée en prévoyant des moyens d'automatisation du fonctionnement des divers organes constitutifs. On peut ainsi prévoir des moyens électroniques de commande pour commander le fonctionnement de l'adaptateur, de l'analyseur de gaz et des moyens d'interface.

En pratique, les moyens électroniques de commande peuvent comprendre un processeur et un programme associé, le programme associé ayant une séquence de mesure dans laquelle le processeur commande la communication entre l'enceinte de transport et l'analyseur de gaz, et ayant l'une au moins des séquences : une séquence de purge dans laquelle le processeur commande l'injection d'un gaz neutre dans l'analyseur de gaz, une séquence d'étalonnage dans laquelle le processeur commande l'injection d'un gaz de référence dans l'analyseur de gaz, une séquence de contrôle externe dans laquelle le processeur commande la mise en communication de l'atmosphère environnante avec l'analyseur de gaz.

Le dispositif selon l'invention peut être installé sur une station de contrôle dédiée sur laquelle les opérateurs peuvent vérifier à tout moment de la chaîne de fabrication le niveau de contamination de l'atmosphère interne de la boite de transport.

Selon un autre aspect, l'invention propose un procédé de contrôle de la contamination des plaquettes de substrat ou autres pièces dans les procédés de fabrication de semi-conducteurs ou de microsystèmes électromécaniques ayant des étapes de transport et/ou de stockage dans des enceintes de transport. Le procédé comprend au moins une étape de mesure dans laquelle on prélève et on isole des gaz à partir de l'atmosphère intérieure d'une enceinte de transport, on ionise les gaz prélevés, et on analyse les gaz par mesure d'un paramètre des ions obtenus par l'ionisation.

Le procédé peut comprendre au moins une étape d'analyse externe au cours de laquelle on prélève des gaz dans l'atmosphère environnante autour de l'enceinte de transport, on ionise les gaz prélevés, et on analyse les gaz prélevés par mesure d'un paramètre des ions obtenus par l'ionisation.

D'autres objets, caractéristiques et avantages de la présente invention ressortiront de la description suivante de modes de réalisation particuliers, faite en relation avec les figures jointes, parmi lesquelles :
- la figure 1 est un schéma général de principe d'un dispositif de contrôle de contamination selon un mode de réalisation de la présente invention ;
- la figure 2 est une vue partielle illustrant un premier mode de réalisation des moyens de mise en communication de l'analyseur de gaz avec l'atmosphère intérieure d'une enceinte de transport à ouverture frontale ;
- la figure 3 est une vue partielle illustrant un second mode de réalisation des moyens de mise en communication de l'analyseur de gaz avec l'atmosphère intérieure de l'enceinte de transport à ouverture frontale ;
- la figure 4 illustre un mode de réalisation des moyens de mise en communication de l'analyseur de gaz avec l'atmosphère intérieure d'une enceinte de transport à ouverture inférieure ; et
- la figure 5 illustre un autre mode de réalisation des moyens pour la mise en communication de l'analyseur de gaz avec l'atmosphère intérieure d'une boîte de transport à ouverture inférieure.

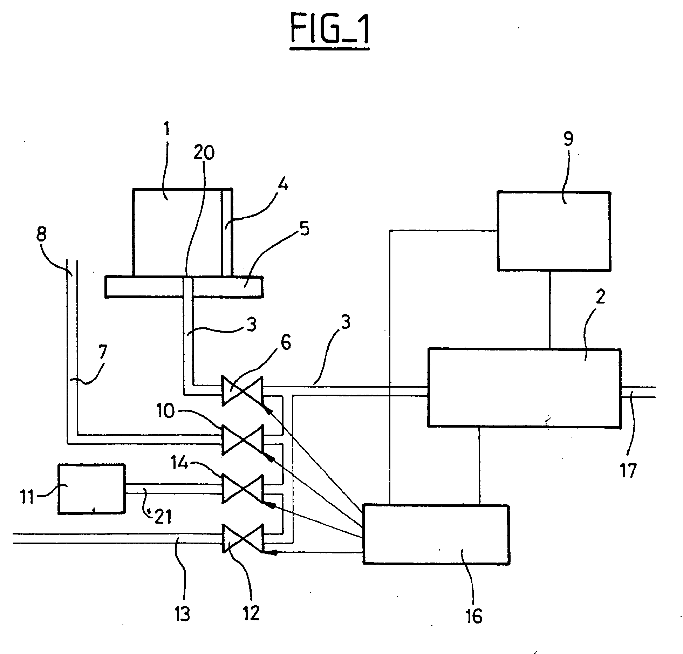

Dans le mode de réalisation illustré sur la figure 1, le dispositif est adapté pour le contrôle de la contamination de plaquettes de substrat ou autres pièces que l'on transporte dans des enceintes de transport 1 pour les transférer d'un poste à l'autre dans une salle blanche.

On utilise par exemple des enceintes de transport standardisées à ouverture frontale de type FOUP, comme illustré sur la figure 1.

De telles enceintes de transport 1 de type FOUP comprennent une porte frontale 4 dimensionnée pour l'introduction et l'extraction des plaquettes de substrat ou autres pièces, et comprennent généralement un ou plusieurs orifices inférieurs 20 munis d'un filtre s'opposant à la pénétration de particules contaminantes vers l'intérieur de l'enceinte de transport 1.

L'enceinte de transport 1 est étanche, mais de façon relativement grossière, c'est-à-dire qu'elle laisse passer l'air ambiant à travers les fuites du joint de la porte 4 et à travers les orifices 20, en privilégiant toutefois la fuite par les filtres des orifices 20. Les orifices 20 comportant des filtres permettent l'entrée et la sortie de l'air ambiant, pour équilibrer les pressions notamment lors de la fermeture et de l'ouverture de la porte 4.

Sur la figure 1, l'enceinte de transport 1 est figurée accouplée sur un adaptateur 5, placé dans la salle blanche, et constituant un poste de contrôle.

L'adaptateur 5 assure la mise en connexion de l'enceinte de transport 1 , par son orifice à filtre 20, avec une canalisation 3 qui conduit les gaz jusqu'à l'entrée d'un analyseur de gaz 2. Une vanne 6 insérée dans la canalisation 3 permet d'ouvrir ou fermer la canalisation 3, pour le passage sélectif des gaz provenant de l'enceinte de transport 1, ou pour leur interruption. La vanne 6 est pilotée par un processeur 16 de type microcontrôleur ou PLC.

L'analyseur de gaz 2 utilise le principe de l'instrumentation IMS (Ion Mobility Spectrometer), capable de mesurer la mobilité des ions, pour assurer la détection des traces de gaz et pour en mesurer la concentration.

Dans un tel analyseur de gaz, un échantillon gazeux est introduit dans la partie réactive d'un tube, où les molécules subissent une ionisation, par exemple par bombardement électronique. Les ions résultant du craquage des molécules sont injectés dans une région où se produit le mouvement des ions pour l'analyse de leur mobilité. La mobilité est déterminée par la vitesse atteinte par les ions positifs puis négatifs dans un champ électrique. Les ions produits sont attirés vers une électrode qui génère un courant électrique. Ce courant électrique est alors traité pour obtenir la concentration des gaz (en ppbv).

En alternative on peut ioniser et analyser l'échantillon gazeux par la technologie IAMS (Ion Attachment Mass Spectrometer).

Un ordinateur 9 est connecté à l'analyseur de gaz 2. L'ordinateur 9 comporte une mémoire permettant le stockage des mesures produites par l'analyseur de gaz 2. Un logiciel enregistré dans l'ordinateur 9 permet d'afficher directement sur un écran les données produites par l'analyseur de gaz 2, et permet de les stocker en mémoire. Des commentaires peuvent être ajoutés lors des mesures, via un écran de saisie. Ainsi, l'ordinateur 9 constitue un moyen électronique de traitement pour traiter et mémoriser les résultats de mesure fournis par l'analyseur de gaz.

Le logiciel de l'ordinateur 9 permet également la gestion des seuils de déclenchement, pour avertir l'utilisateur lorsque ces seuils sont dépassés.

Le logiciel de l'ordinateur 9 permet également le paramétrage du processeur 16, auquel l'ordinateur 9 est également connecté.

En fonctionnement de mesure de contamination interne, les gaz contenus à l'intérieur de l'enceinte de transport 1 sont aspirés par la canalisation 3 jusqu'à l'analyseur de gaz 2, qui le refoule ensuite dans la salle blanche par le refoulement 17. Au passage dans l'analyseur de gaz 2, les gaz sont analysés et les informations qui en résultent sont envoyées à l'ordinateur 9.

La canalisation 3 et l'adaptateur 5 présentent une étanchéité suffisante pour éviter la pénétration de gaz parasites provenant de la salle blanche vers l'intérieur de la canalisation 3 et vers l'analyseur de gaz 2. On s'assure ainsi que l'analyseur de gaz 2 analyse essentiellement les gaz provenant de l'atmosphère intérieure de l'enceinte de transport 1. Ainsi, le flux de gaz à analyser par l'analyseur de gaz 2 provient majoritairement de l'enceinte de transport 1, le flux résultant des fuites provenant de l'atmosphère extérieure à l'enceinte de transport 1 étant minoritaire.

Selon un mode préféré de l'invention, l'enceinte de transport 1 peut être positionnée sur l'adaptateur 5 au moyen de picots de positionnement normalisés.

Etant donné que le positionnement des orifices 20 à filtre n'est pas normalisé sur les enceintes de transport 1, même lorsque celles-ci sont normalisées de type FOUP, on prévoit que la position de l'adaptateur 5 est ajustable pour se connecter au filtre préexistant de l'enceinte de transport 1.

Si l'enceinte de transport 1 ne comporte pas d'orifice d'entrée 20 dans sa paroi inférieure, l'adaptateur 5 comporte alors des moyens d'ouverture de la porte de l'enceinte de transport 1, et des moyens collecteurs assurant un isolement suffisant vis-à-vis de l'atmosphère de la salle blanche. On prévoit alors que la mesure est prise à l'entrouverture de la porte 4 de l'enceinte de transport 1, comme cela sera décrit plus loin.

Dans le mode de réalisation illustré sur la figure 1, la canalisation 3 comporte, en aval de la vanne 6, trois dérivations respectivement 7, 13 et 21, munies chacune d'une vanne respective 10, 12 et 14. La dérivation 7 débouche dans l'atmosphère intérieure de la salle blanche, par un orifice 8, au voisinage de l'adaptateur 5. La dérivation 13 conduit à une source de gaz de référence. La dérivation 21 conduit à une source de gaz neutre 11.

Les vannes 10, 12 et 14 sont également pilotées par le processeur 16.

Une telle disposition permet respectivement:
- une mesure de l'atmosphère extérieure au voisinage de l'enceinte de transport 1 accouplée à l'adaptateur 5, par l'orifice 8, la dérivation 7 et la vanne 10, pour quantifier le bruit de fond correspondant au niveau de pollution de la salle blanche ;
- une alimentation en gaz neutre tel que l'azote à partir de la source de gaz neutre 11, pour purger la cellule de mesure de l'analyseur de gaz 2 ;
- une mesure d'un gaz de référence pour vérifier l'étalonnage de la cellule de mesure de l'analyseur de gaz 2.

Le processeur 16 peut gérer le séquencement des commandes des vannes, pour réaliser ces différentes mesures.

Pour cela, le processeur 16 comprend un programme associé, le programme ayant une séquence de mesure dans laquelle le processeur commande la communication entre l'enceinte de transport 1 et l'analyseur de gaz 2, et l'une au moins des séquences : une séquence de purge dans laquelle le processeur commande l'injection d'un gaz neutre dans l'analyseur de gaz 2 à partir de la source de gaz neutre 11, une séquence d'étalonnage dans laquelle le processeur commande l'injection d'un gaz de référence par la dérivation 13, une séquence de contrôle externe dans laquelle le processeur commande la mise en communication de l'atmosphère environnante avec l'analyseur de gaz 2 par la dérivation 7 et l'orifice 8.

Dans la réalisation illustrée sur les figures, on prévoit une vanne distincte 6, 10, 12 ou 14 dans chaque canalisation 3 ou dérivation 7, 13 ou 21.

En alternative, on pourra utiliser des vannes trois voies pour assurer la même fonction.

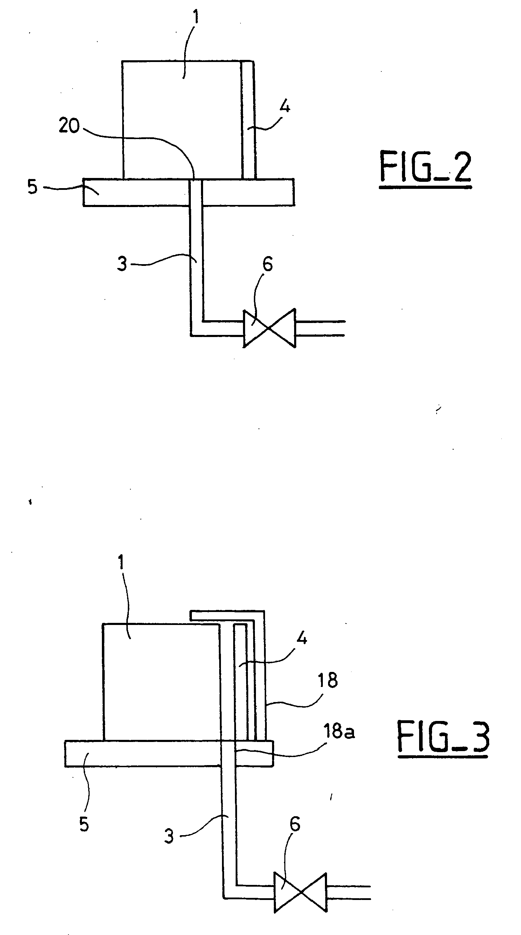

On considère maintenant les figures 2 à 5, qui illustrent quatre modes de réalisation de l'adaptateur 5, pour une adaptation à différents types d'enceinte de transport.

La figure 2 reprend la structure illustrée sur la figure 1, avec un adaptateur 5 conformé pour constituer un plan support sur lequel vient reposer une enceinte de transport 1 normalisée à ouverture frontale de type FOUP. On distingue la porte frontale 4, l'orifice inférieur 20 à filtre qui se connecte à la canalisation 3 munie d'une vanne 6.

Sur la figure 3, l'adaptateur 5 est conçu pour coopérer avec une enceinte de transport 1 à ouverture frontale mais dépourvue d'orifice inférieur 20 susceptible d'être connecté à la canalisation 3. Dans ce cas, l'adaptateur 5 comprend un collecteur 18, réalisant une enceinte de prélèvement enfermant la porte frontale 4 et autorisant l'ouverture au moins partielle de la porte frontale 4. L'enceinte de prélèvement définie par le collecteur 18 est raccordée à la canalisation 3 par un orifice inférieur 18a.

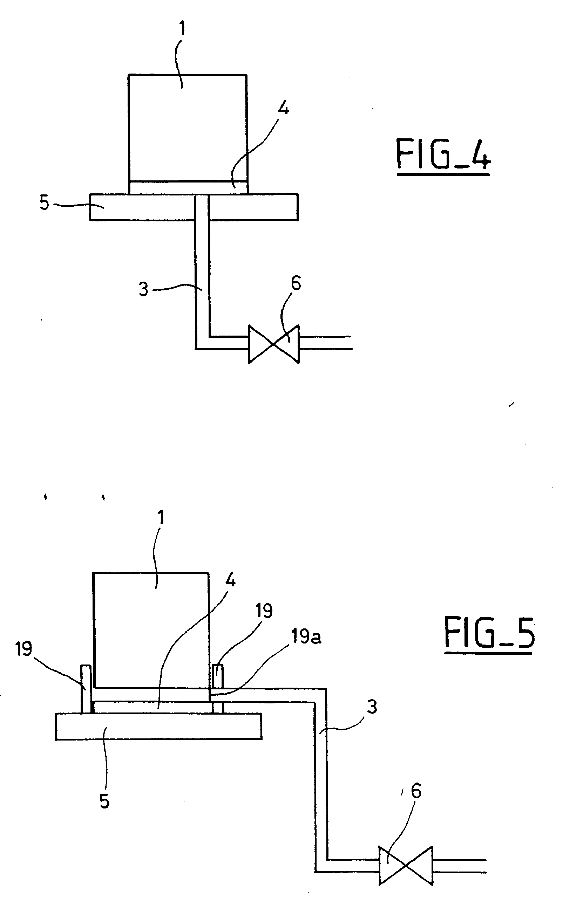

Sur la figure 4, l'adaptateur 5 est conformé pour coopérer avec une enceinte de transport 1 à ouverture inférieure, par exemple une enceinte normalisée de type SMIF. Dans ce cas, la porte de l'enceinte de transport 1 est une porte inférieure 4, elle-même munie d'un orifice auquel on peut connecter la canalisation 3 à travers l'adaptateur 5.

Sur la figure 5, on a illustré une structure d'adaptateur 5 conformée pour coopérer avec une enceinte de transport 1 de type SMIF, c'est-à-dire à ouverture inférieure, mais dans laquelle la porte inférieure 4 est dépourvue d'orifice pouvant être connecté à la canalisation 3. Dans ce cas, l'adaptateur 5 comprend un collecteur 19 définissant une enceinte de prélèvement autour de l'ouverture de l'enceinte de transport 1 et autorisant une ouverture au moins partielle de la porte inférieure 4. Un orifice latéral 19a permet de connecter la canalisation 3 à l'intérieur de l'enceinte de prélèvement dans le collecteur 19.

En fonctionnement, le dispositif assure une mesure de la contamination présente dans une enceinte de transport 1, mesure au cours de laquelle on prélève des gaz dans l'enceinte de transport 1, on ionise les gaz prélevés et on analyse les gaz par mesure d'un paramètre des ions obtenus par l'ionisation.

Le procédé de mesure peut avantageusement comprendre au moins une étape d'analyse externe au cours de laquelle on prélève des gaz dans l'atmosphère environnante autour de l'enceinte de transport 1, par la dérivation 7 et l'orifice 8, on ionise les gaz prélevés, et on analyse les gaz par mesure d'un paramètre des ions obtenus par l'ionisation.

Le procédé peut comprendre au moins une étape de purge au cours de laquelle on injecte un gaz neutre tel que l'azote dans l'analyseur de gaz 2.

Le procédé peut comprendre une étape d'étalonnage au cours de laquelle on injecte un gaz de référence par la dérivation 13 dans l'analyseur de gaz 2.

Le procédé défini ci-dessus est une première application de l'invention, conduisant à la mesure de la contamination présente dans l'atmosphère intérieure de l'enceinte de transport 1, qui est une approximation de la contamination présente sur les plaquettes de substrat ou autres pièces que l'enceinte de transport 1 peut contenir.

Selon une seconde application, le procédé peut comprendre une séquence de mesure différentielle, comprenant une mesure de la contamination dans l'enceinte de transport 1 avant un procédé de traitement appliqué aux plaquettes de substrat contenues dans l'enceinte de transport 1, et une mesure de la contamination dans l'enceinte de transport 1 après ledit procédé de traitement et après réintroduction des plaquettes de substrat traitées dans l'enceinte de transport 1.

Selon une autre application, le procédé peut comprendre une étape préalable de contrôle au cours de laquelle on mesure la contamination dans l'enceinte de transport 1 ouverte ou fermée, avant introduction des plaquettes de substrat ou autres pièces.

Selon une autre application, on peut mesurer la contamination dans une enceinte de transport 1 après enlèvement des plaquettes de substrat ou autres pièces. L'enceinte ayant une faible conductance, la présence des gaz contaminants peut rester plusieurs heures à l'intérieur de l'enceinte. On a donc une traçabilité des événements sur les substrats ou autres pièces pendant plusieurs heures, selon un effet mémoire.

Selon une autre application, une enceinte de transport ouverte ou percée peut être placée dans différentes zones de la salle blanche. Après positionnement dans une zone donnée de la salle blanche, l'enceinte peut être refermée, puis transportée jusqu'au système de contrôle pour mesurer la contamination. Ainsi, l'invention permet de connaître les contaminants dans toutes les zones de la salle blanche.

L'intérêt de l'invention est de permettre d'effectuer une mesure en temps réel des faibles niveaux de contamination induite par les gaz en plusieurs zones avec un seul dispositif.

Les mesures de contaminations sont effectuées sans risque de contamination supplémentaire des substrats ou autres pièces contenus dans les enceintes de transport, contamination qui pourrait être induite par l'adjonction de matériaux de test tels que les polymères adsorbants.

La mesure de contamination peut se faire dans l'enceinte de transport 1 sans même à avoir à enlever les plaquettes de substrat ou autres pièces.

La présente invention n'est pas limitée aux modes de réalisation qui ont été explicitement décrits, mais elle en inclut les diverses variantes et généralisations qui sont à la portée de l'homme du métier.

## Revendications

1. Dispositif pour le contrôle de la contamination des plaquettes de substrat ou autres pièces dans les procédés de fabrication de semi-conducteurs ou de microsystèmes électromécaniques ayant des étapes de transport et/ou de stockage des plaquettes de substrat ou autres pièces dans des enceintes de transport (1), comprenant un analyseur de gaz (2) ayant des moyens pour ioniser des gaz et des moyens pour identifier les gaz ionisés par la mesure d'un paramètre des ions, **caractérisé en ce que** les moyens pour ioniser les gaz sont aptes à ioniser des gaz à pression atmosphérique, et **en ce que** le dispositif comprend en outre des moyens d'interface (3, 5, 6) pour mettre en communication directe l'analyseur de gaz (2) avec l'atmosphère interne d'au moins une enceinte de transport (1), lesdits moyens étant aptes à conduire, directement et sans apport extérieur significatif, un flux de gaz à analyser depuis l'atmosphère interne d'au moins une enceinte de transport (1) jusqu'à l'analyseur de gaz (2).

2. Dispositif selon la revendication 1, dans lequel les moyens d'interface sont constitué d'un matériau qui est le perfluoroalkoxy (PFA).

3. Dispositif selon l'une des revendications 1 et 2, dans lequel les moyens d'interface (5) comportent des moyens d'isolement garantissant que le flux de gaz à analyser parvenant à l'analyseur de gaz (2) provient majoritairement de l'enceinte de transport (1), le flux résultant des fuites provenant de l'atmosphère extérieure à l'enceinte de transport (1) étant minoritaire.

4. Dispositif selon l'une des revendications précédentes, **caractérisé en ce qu'**il comprend en outre au moins une enceinte de transport (1).

5. Dispositif selon l'une des revendications 1 à 4, dans lequel l'analyseur de gaz (2) est d'un type permettant de mesurer la mobilité des ions.

6. Dispositif selon l'une des revendications 1 à 4, dans lequel l'analyseur de gaz (2) est d'un type permettant de mesurer le temps de vol des ions.

7. Dispositif selon l'une revendications 1 à 4, dans lequel l'analyseur de gaz (2) est d'un type permettant de mesurer la masse des ions.

8. Dispositif selon l'une des revendications 5 et 6, dans lequel l'ionisation des gaz est réalisée par bombardement électronique.

9. Dispositif selon l'une des revendications 5 à 7, dans lequel l'ionisation des gaz est réalisée par bombardement d'ions alcalins qui s'attachent aux molécules de gaz.

10. Dispositif selon l'une des revendications précédentes, dans lequel les moyens d'interface (5) comprennent :
- au moins un passage (20) traversant la paroi de l'enceinte de transport (1),
- un adaptateur (5) conformé de façon que l'enceinte de transport (1) puisse être accouplée sur l'adaptateur (5) avec ledit passage (20) mis sélectivement en communication avec une canalisation (3) conduisant à l'analyseur de gaz (2).

11. Dispositif selon la revendication 10, dans lequel l'adaptateur (5) comprend des moyens de positionnement pour placer l'enceinte de transport (1) en une position telle que ledit passage (20) est face à l'orifice de la canalisation (3) conduisant à l'analyseur de gaz (2).

12. Dispositif selon la revendication 11, dans lequel les moyens de positionnement comprennent au moins un picot pour s'engager dans un trou correspondant.

13. Dispositif selon l'une des revendications 1 à 9, dans lequel l'enceinte de transport (1) comprend au moins une porte (4), et ledit dispositif comprend au moins un adaptateur (5) comprenant des moyens pour ouvrir sélectivement ladite porte (4), et des moyens collecteurs (18, 19) pour prélever les gaz de l'enceinte de transport (1) et les transmettre à l'analyseur de gaz (2) tout en limitant le prélèvement de gaz de fuite issus de l'atmosphère environnante.

14. Dispositif selon l'une des revendications 10 à 13, dans lequel l'adaptateur est intégré directement sur des moyens de chargement des boites de transport.

15. Dispositif selon l'une des revendications 1 à 9, dans lequel les moyens d'interface (5) comprennent une aiguille capable de percer la paroi d'une enceinte de transport (1) et raccordée à l'analyseur de gaz (2).

16. Dispositif selon l'une des revendications précédentes, comprenant des moyens (11, 14) pour injecter sélectivement un gaz neutre de purge dans l'analyseur de gaz (2).

17. Dispositif selon la revendication 16, dans lequel les moyens pour injecter sélectivement un gaz neutre comprennent une source d'azote (11).

18. Dispositif selon l'une des revendications précédentes, comprenant des moyens (7, 8, 10) pour mettre sélectivement en communication directe l'entrée de l'analyseur de gaz (2) avec l'atmosphère environnante autour de l'enceinte de transport (1).

19. Dispositif selon l'une des revendications précédentes, comprenant des moyens électroniques de commande (16) pour commander le fonctionnement de l'adaptateur (5), de l'analyseur de gaz (2) et des moyens d'interface (6, 10, 12, 14).

20. Dispositif selon l'une des revendications précédentes, comprenant des moyens électroniques de traitement (9) pour traiter et mémoriser les résultats de mesure fournis par l'analyseur de gaz (2).

21. Dispositif selon la revendication 19, dans lequel les moyens électroniques de commande comprennent un processeur (16) et un programme associé, le programme associé ayant une séquence de mesure dans laquelle le processeur (16) commande la communication entre l'enceinte de transport (1) et l'analyseur de gaz (2) et ayant l'une au moins des séquences: une séquence de purge dans laquelle le processeur (16) commande l'injection d'un gaz neutre dans l'analyseur de gaz (2), une séquence d'étalonnage dans laquelle le processeur (16) commande l'injection d'un gaz de référence dans l'analyseur de gaz (2), une séquence de contrôle externe dans laquelle le processeur (16) commande la mise en communication de l'atmosphère environnante avec l'analyseur de gaz (2).

22. Procédé de contrôle de la contamination des plaquettes de substrat ou autres pièces dans les procédés de fabrication de semi-conducteurs ou de microsystèmes électromécaniques ayant des étapes de transport et/ou de stockage dans des enceintes de transport (1), **caractérisé en ce qu'**il comprend au moins une étape de mesure dans laquelle on prélève et on isole des gaz à partir de l'atmosphère intérieure d'une enceinte de transport (1), on ionise les gaz prélevés, et on analyse les gaz prélevés par mesure d'un paramètre des ions obtenus par l'ionisation.

23. Procédé selon la revendication 22, comprenant en outre au moins une étape d'analyse externe au cours de laquelle on prélève des gaz dans l'atmosphère environnante autour de l'enceinte de transport (1), on ionise les gaz prélevés, et on analyse les gaz prélevés par mesure d'un paramètre des ions obtenus par l'ionisation.

24. Procédé selon l'une des revendications 22 et 23, comprenant en outre au moins une étape de purge au cours de laquelle on injecte un gaz neutre tel que l'azote dans l'analyseur de gaz (2).

25. Procédé selon l'une des revendications 22 à 24, comprenant en outre une étape d'étalonnage au cours de laquelle on injecte un gaz de référence dans l'analyseur de gaz (2).

26. Procédé selon l'une des revendications 22 à 25, comprenant en outre une séquence de mesure différentielle, comprenant une mesure de la contamination dans l'enceinte de transport (1) avant un procédé de traitement appliqué aux plaquettes de substrat contenues dans l'enceinte de transport (1), et une mesure de la contamination dans l'enceinte de transport (1) après ledit procédé de traitement et réintroduction des plaquettes de substrat traitées dans l'enceinte de transport (1).

27. Procédé selon l'une des revendications 22 à 26, comprenant en outre une étape préalable de contrôle, au cours de laquelle on mesure la contamination dans l'enceinte de transport (1) ouverte ou fermée avant introduction des plaquettes de substrat ou autres pièces.

## Claims

1. Device for monitoring the contamination of substrate wafers or other parts in semiconductor or microelectromechanical system fabrication processes including steps of transporting and/or storing said substrate wafers or other parts in transport enclosures (1), said device including a gas analyzer (2) including means for ionizing gases and means for identifying the ionized gases by measuring a parameter of the ions, **characterized in that** the means for ionizing gases are adapted to ionize gases at atmospheric pressure, and **in that** the device further includes interface means (3, 5, 6) for setting up direct communication between the gas analyzer (2) and the internal atmosphere of at least one transport enclosure (1), said means being adapted to convey a flow of gas to be analyzed from the internal atmosphere of at least one transport enclosure (1) to the gas analyzer (2) directly and without significant external input.

2. Device according to Claim 1, wherein the interface means consist of a material which is perfluoroalkoxy (PFA).

3. Device according to either of Claims 1 and 2, wherein the interface means (5) include isolating means to guarantee that the flow of gas to be analyzed reaching the gas analyzer (2) comes for the most part from the transport enclosure (1), the flow resulting from leaks from the atmosphere external to the transport enclosure (1) being in the minority.

4. Device according to one of the preceding claims, **characterized in that** it further includes at least one transport enclosure (1).

5. Device according to one of Claims 1 to 4, wherein the gas analyzer (2) is of a type adapted to measure the mobility of the ions.

6. Device according to one of Claims 1 to 4, wherein the gas analyzer (2) is of a type adapted to measure the flight time of the ions.

7. Device according to one of Claims 1 to 4, wherein the gas analyzer (2) is of a type adapted to measure the mass of the ions.

8. Device according to either of Claims 5 and 6, wherein the gases are ionized by electron bombardment.

9. Device according to one of Claims 5 to 7, wherein the gases are ionized by bombardment with alkaline ions that become attached to the gas molecules.

10. Device according to one of the preceding claims, wherein the interface means (5) include:
- at least one passage (20) through the wall of the transport enclosure (1), and
- an adapter (5) conformed so that the transport enclosure (1) can be coupled to the adapter (5) with said passage (20) selectively placed in communication with a pipe (3) leading to the gas analyzer (2).

11. Device according to Claim 10, wherein the adapter (5) includes locating means for positioning the transport enclosure (1) so that said passage (20) faces the orifice of the pipe (3) leading to the gas analyzer (2).

12. Device according to Claim 11, wherein the locating means include at least one lug adapted to engage in a corresponding hole.

13. Device according to one of Claims 1 to 9, wherein the transport enclosure (1) has at least one door (4) and said device includes at least one adapter (5) including means for selectively opening said door (4) and collector means (18, 19) for sampling gases from the transport enclosure (1) and transferring them to the gas analyzer (2), while limiting the sampling of gases leaking in from the surrounding atmosphere.

14. Device according to one of Claims 10 to 13, wherein the adapter is integrated directly into transport pod loading means.

15. Device according to one of Claims 1 to 9, wherein the interface means (5) include a needle connected to the gas analyzer (2) and adapted to pierce the wall of a transport enclosure (1).

16. Device according to one of the preceding claims, including means (11, 14) for selectively injecting a purging neutral gas into the gas analyzer (2).

17. Device according to Claim 16, wherein the means for selectively injecting a neutral gas include a source of nitrogen (11).

18. Device according to one of the preceding claims, including means (7, 8, 10) for selectively setting up direct communication between the inlet of the gas analyzer (2) and the atmosphere surrounding the transport enclosure (1).

19. Device according to one of the preceding claims, including electronic control means (16) for controlling the operation of the adapter (5), the gas analyzer (2) and the interface means (6, 10, 12, 14).

20. Device according to one of the preceding claims, including electronic processing means (9) for processing and storing measurement results supplied by the gas analyzer (2).

21. Device according to Claim 19, wherein the electronic control means include a processor (16) and an associated program, the associated program including a measurement sequence in which the processor (16) commands communication between the transport enclosure (1) and the gas analyzer (2) and including at least one of the following sequences: a purge sequence in which the processor (16) commands the injection of a neutral gas into the gas analyzer (2); a calibration sequence in which the processor (16) commands the injection of a reference gas into the gas analyzer (2); and an external monitoring sequence in which the processor (16) commands the setting up of communication between the gas analyzer (2) and the surrounding atmosphere.

22. Method of monitoring the contamination of wafer substrates or other parts in semiconductor or microelectromechanical system fabrication processes including transport and/or storage steps in transport enclosures (1), **characterized in that** it includes at least one measurement step in which gases are sampled from the interior atmosphere of a transport enclosure (1) and isolated, the sampled gases are ionized and the sampled gases are analyzed by measuring a parameter of the ions obtained by ionization.

23. Method according to Claim 22, further including at least one step of external analysis during which gases are sampled in the atmosphere surrounding the transport enclosure (1), the sampled gases are ionized and the sampled gases are analyzed by measuring a parameter of the ions obtained by ionization.

24. Method according to either of Claims 22 and 23, further including at least one purge step during which a neutral gas such as nitrogen is injected into the gas analyzer (2).

25. Method according to one of Claims 22 to 24, further including a calibration step during which a reference gas is injected into the gas analyzer (2).

26. Method according to one of Claims 22 to 25, further including a differential measurement sequence including measurement of the contamination in the transport enclosure (1) before a treatment process is applied to the substrate wafers contained in the transport enclosure (1) and measurement of the contamination in the transport enclosure (1) after said treatment process and reintroduction of the treated substrate wafers into the transport enclosure (1).

27. Method according to one of Claims 22 to 26, further including a preliminary monitoring step during which the contamination in the open or closed transport enclosure (1) is measured before introducing the substrate wafers or other parts into it.

## Patentansprüche

1. Vorrichtung zur Kontrolle der Kontamination der Substratplatten oder sonstiger Teile bei den Verfahren zur Herstellung von Halbleitern oder elektromechanischen Mikrosystemen, die Schritte des Transports und/oder der Lagerung der Substratplatten oder sonstiger Teile in Transporträumen (1) beinhalten, umfassend einen Gasanalysator (2) mit Mitteln zum Ionisieren der Gase und Mitteln, um die ionisierten Gase durch das Messen eines Parameters der Ione zu identifizieren, **dadurch gekennzeichnet, dass** die Mittel zum Ionisieren der Gase geeignet sind, Gase bei Luftdruck zu ionisieren, und dass die Vorrichtung ferner Schnittstellenmittel (3, 5, 6) umfasst, um den Gasanalysator (2) mit der inneren Atmosphäre mindestens eines Transportraums (1) in direkte Verbindung zu bringen, wobei die Mittel geeignet sind, direkt und ohne signifikante Zugabe von außen einen zu analysierenden Gasstrom von der inneren Atmosphäre mindestens eines Transportraums (1) zu dem Gasanalysator (2) zu leiten.

2. Vorrichtung nach Anspruch 1, bei der die Schnittstellenmittel aus einem Material bestehen, das Perfluoralkoxy (PFA) ist.

3. Vorrichtung nach einem der Ansprüche 1 und 2, bei der die Schnittstellenmittel (5) Isoliermittel umfassen, die garantieren, dass der zu analysierende Gasstrom, der zum Gasanalysator (2) gelangt, hauptsächlich vom Transportraum (1) kommt, wobei der restliche Leckagestrom, der von der äußeren Atmosphäre zum Transportraum (1) kommt, in der Minderheit ist.

4. Vorrichtung nach einem der vorhergehenden Ansprüche, **dadurch gekennzeichnet, dass** sie ferner mindestens einen Transportraum (1) umfasst.

5. Vorrichtung nach einem der Ansprüche 1 bis 4, bei der es der Gasanalysator (2) ermöglicht, die Mobilität der Ionen zu messen.

6. Vorrichtung nach einem der Ansprüche 1 bis 4, bei der es der Gasanalysator (2) ermöglicht, die Laufzeit der Ionen zu messen.

7. Vorrichtung nach einem der Ansprüche 1 bis 4, bei der es der Gasanalysator (2) ermöglicht, die Masse der Ionen zu messen.

8. Vorrichtung nach einem der Ansprüche 5 und 6, bei der die Ionisierung der Gase durch Elektronenbeschuss erfolgt.

9. Vorrichtung nach einem der Ansprüche 5 bis 7, bei der die Ionisierung der Gase durch Beschuss von Alkaliionen, die sich an die Gasmoleküle anheften, erfolgt.

10. Vorrichtung nach einem der vorhergehenden Ansprüche, bei der die Schnittstellenmittel (5) Folgendes umfassen:
- mindestens einen Durchgang (20) durch die Wand des Transportraums (1),
- einen Adapter (5), der derart ausgeführt ist, dass der Transportraum (1) an den Adapter (5) angekoppelt werden kann, wobei der Durchgang (20) selektiv mit einem Kanal (3), der zum Gasanalysator (2) führt, in Verbindung gebracht werden kann.

11. Vorrichtung nach Anspruch 10, bei der der Adapter (5) Positioniermittel umfasst, um den Transportraum (1) in eine derartige Position zu bringen, dass der Durchgang (20) der Öffnung des Kanals (3), der zum Gasanalysator (2) führt, gegenüber liegt.

12. Vorrichtung nach Anspruch 11, bei der die Positioniermittel mindestens einen Keil umfassen, um in ein entsprechendes Loch einzurasten.

13. Vorrichtung nach einem der Ansprüche 1 bis 9, bei der der Transportraum (1) mindestens eine Tür (4) umfasst, und die Vorrichtung mindestens einen Adapter (5) umfasst, umfassend Mittel, um die Tür (4) selektiv zu öffnen, und Sammelmittel (18, 19), um die Gase aus dem Transportraum (1) zu entnehmen und sie zum Gasanalysator (2) zu leiten, wobei die Entnahme von Leckagegasen, die aus der umgebenden Atmosphäre stammen, begrenzt wird.

14. Vorrichtung nach einem der Ansprüche 10 bis 13, bei der der Adapter direkt in die Mittel zum Beladen der Transportkisten integriert ist.

15. Vorrichtung nach einem der Ansprüche 1 bis 9, bei der die Schnittstellenmittel (5) eine Nadel umfassen, die geeignet ist, die Wand eines Transportraums (1) zu durchstoßen, und die an den Gasanalysator (2) angeschlossen ist.

16. Vorrichtung nach einem der vorhergehenden Ansprüche, umfassend Mittel (11, 14), um selektiv ein Neutralgas zur Reinigung in den Gasanalysator (2) einzuleiten.

17. Vorrichtung nach Anspruch 16, bei der die Mittel zum selektiven Einleiten eines Neutralgases eine Stickstoffquelle (11) umfassen.

18. Vorrichtung nach einem der vorhergehenden Ansprüche, umfassend Mittel (7, 8, 10), um den Eingang des Gasanalysators (2) selektiv mit der umgebenden Atmosphäre des Transportraums (1) in direkte Verbindung zu bringen.

19. Vorrichtung nach einem der vorhergehenden Ansprüche, umfassend elektronische Steuermittel (16), um die Funktion des Adapters (5), des Gasanalysators (2) und der Schnittstellenmittel (6, 10, 12, 14) zu steuern.

20. Vorrichtung nach einem der vorhergehenden Ansprüche, umfassend elektronische Bearbeitungsmittel (9), um die Messergebnisse, die vom Gasanalysator (2) geliefert werden, zu bearbeiten und zu speichern.

21. Vorrichtung nach Anspruch 19, bei der die elektronischen Steuermittel einen Prozessor (16) und ein zugehöriges Programm umfassen, wobei das zugehörige Programm eine Messsequenz hat, bei der der Prozessor (16) die Verbindung zwischen dem Transportraum (1) und dem Gasanalysator (2) steuert, und wobei mindestens eine der folgenden Sequenzen vorhanden ist: eine Reinigungssequenz, bei der der Prozessor (16) das Einleiten eines Neutralgases in den Gasanalysator (2) steuert, eine Eichungssequenz, bei der der Prozessor (16) das Einleiten eines Referenzgases in den Gasanalysator (2) steuert, eine externe Kontrollsequenz, bei der der Prozessor (16) die Verbindung der umgebenden Atmosphäre mit dem Gasanalysator (2) steuert.

22. Verfahren zur Kontrolle der Kontamination der Substratplatten oder sonstiger Teile bei den Verfahren zur Herstellung von Halbleitern oder von elektromechanischen Mikrosystemen, die Schritte des Transports und/oder der Lagerung in Transporträumen (1) beinhalten, **dadurch gekennzeichnet, dass** es mindestens einen Messschritt umfasst, bei dem Gase aus der inneren Atmosphäre eines Transportraums (1) entnommen und isoliert werden, die entnommenen Gase ionisiert werden und die entnommenen Gase durch Messen eines Parameters der durch Ionisierung gewonnenen Ionen analysiert werden.

23. Verfahren nach Anspruch 22, ferner umfassend mindestens einen externen Analyseschritt, während dessen Gase aus der umgebenden Atmosphäre des Transportraums (1) entnommen werden, die entnommenen Gase ionisiert werden und die entnommenen Gase durch Messen eines Parameters der durch Ionisierung gewonnenen Ionen analysiert werden.

24. Verfahren nach einem der Ansprüche 22 und 23, ferner umfassend mindestens einen Reinigungsschritt, während dessen ein Neutralgas, wie Stickstoff, in den Gasanalysator (2) eingeleitet wird.

25. Verfahren nach einem der Ansprüche 22 bis 24, ferner umfassend einen Eichungsschritt, während dessen ein Referenzgas in den Gasanalysator (2) eingeleitet wird.

26. Verfahren nach einem der Ansprüche 22 bis 25, ferner umfassend eine Differentialmesssequenz, umfassend eine Messung der Kontamination in dem Transportraum (1) vor einem Behandlungsverfahren, das an den in dem Transportraum (1) enthaltenen Substratplatten angewandt wird, und eine Messung der Kontamination in dem Transportraum (1) nach dem Behandlungsverfahren und Wiedereinbringung der behandelten Substratplatten in den Transportraum (1).

27. Verfahren nach einem der Ansprüche 22 bis 26, ferner umfassend einen vorherigen Kontrollschritt, während dessen die Kontamination in dem offenen oder geschlossenen Transportraum (1) vor Einbringung der Substratplatten oder sonstiger Teile gemessen wird.
